# FASCICULE DE BREVET EUROPEEN

(11) **EP 3 034 932 B1**
(45) Date de publication et mention de la délivrance du brevet: **13.09.2017**
(21) Numéro de dépôt: 15200851.2
(22) Date de dépôt: 17.12.2015
(51) Int. Cl.: F21S 8/10, F21V 19/00, H05K 1/02, H05K 1/11, H05K 3/00, H05K 3/10, F21Y 115/10, F21Y 107/00, F21Y 111/00

(54) **DISPOSITIF D'ÉCLAIRAGE ET/OU DE SIGNALISATION COMPORTANT UNE PLURALITÉ DE DIODES ÉLECTROLUMINESCENTES**
BELEUCHTUNGS- UND/ODER SIGNALISIERUNGSVORRICHTUNG, DIE EINE VIELZAHL VON ELEKTROLUMINESZENZDIODEN UMFASST
LIGHTING AND/OR SIGNALLING DEVICE COMPRISING A PLURALITY OF LIGHT EMITTING DIODES

(30) Priorité: 19.12.2014 FR 1462956
(43) Date de publication de la demande: 22.06.2016
(73) Titulaire: VALEO VISION, 93012 Bobigny Cedex (FR)
(72) Inventeur: MAITRE, Michael, 95490 VAUREAL (FR)

(56) Documents cités:
- EP-A1- 1 110 817
- EP-A2- 2 141 406
- DE-A1-102012 218 059
- JP-A- 2014 135 128
- KR-A- 20100 002 455
- KR-A- 20120 076 197
- US-A1- 2009 242 239
- US-A1- 2013 077 334
- US-B2- 8 657 468

## Description

La présente invention concerne un dispositif d'éclairage et/ou de signalisation du type comportant une pluralité de diodes électroluminescentes. Elle concerne plus particulièrement le support de ces diodes électroluminescentes et la forme spécifique en trois dimensions de ce support.

Dans les modules d'éclairage et/ou de signalisation, notamment pour les véhicules automobiles, on utilise de plus en plus souvent des diodes électroluminescentes, notamment pour les avantages d'encombrement, d'autonomie et de coût qu'ils représentent. Ces diodes électroluminescentes doivent être alimentées par des circuits électriques conduisant le courant d'un connecteur vers la diode. Ces circuits électriques d'alimentation peuvent être gravés sur une plaque de circuit imprimés ou être, comme cela est le cas dans une technologie plus récente, directement injecté dans ou rapportés à la surface d' une pièce plastique pour former un dispositif interconnecté moulé (MID : Molded Interconnecting device).

L'utilisation de diodes électroluminescentes dans les modules d'éclairage et/ou de signalisation a permis au créateur de véhicule automobile d'apporter une touche créative dans la conception des dispositifs d'éclairage. Ainsi, l'utilisation de plusieurs diodes électroluminescentes permet de jouer sur l'esthétique, aussi bien que sur la qualité de l'éclairage du dispositif. Les concepteurs ont également utilisé des pièces en trois dimensions pour disposer dans un agencement souhaité, l'ensemble des diodes.

On connaît ainsi des supports de diodes en trois dimensions qui présentent la forme de marche d'escalier, chacune des diodes étant disposée sur l'une de ces marches en étant orientées toutes dans la même direction. Pour que l'ensemble des diodes soit alors alimenté par le circuit électrique d'alimentation, il convient d'appliquer les circuits imprimés sur chacune des faces du support en trois dimensions. L'utilisation de plaques de circuits imprimés rigides rapportées sur chacune des faces n'est pas envisagée, puisque cela implique un process de collage des plaques trop fastidieux si le nombre de diodes est important. Par ailleurs, la connexion électrique entre les plaques planes n'est pas assurée, et la rigidité des plaques de circuits imprimés est difficilement compatible avec le souhait de supports tridimensionnels.

On connaît du document EP 2 141 406 l'obtention d'un tel support de diodes en trois dimensions et des circuits imprimés associés par la réalisation d'un dispositif interconnecté moulé, les pistes conductrices étant intégrées dans la pièce moulée par injection plastique. Le dispositif interconnecté moulé est obtenu par des techniques de fabrication coûteuses, et qui génèrent des épaisseurs de métal peu importantes. Or, il est important lorsqu'on utilise des diodes de forte puissance d'assurer un traitement thermique par une épaisseur de métal suffisamment grande. Les techniques utilisées auparavant pour la réalisation du dispositif interconnecté moulé, comme la galvanisation de chacune des faces du support de diode puis la gravure de ces faces par ablation laser, ne permettent pas l'obtention de telles épaisseurs de métal

On connaît également des circuits imprimés flexibles, fabriqués selon une technologie de circuit imprimé qui consiste à utiliser un substrat plastique sur lequel les circuits sont sérigraphiés. Ces circuits imprimés flexibles sont adaptés à prendre une forme particulière pour leur intégration optimisée dans le module d'éclairage et/ou de signalisation. Les problèmes principaux de ce type de réalisation est leur coût, non compatible avec l'exigence de faible coût de revient des applications grandes séries, ainsi que leur moindre résistance.

La présente invention propose un support de diode en trois dimensions, obtenu par des opérations de fabrication peu coûteuse, simple à mettre en place, et qui génère un support de diode à forte capacité de refroidissement des diodes.

A cet effet, l'invention propose un dispositif d'éclairage et/ou de signalisation comportant une pluralité de diodes électroluminescentes rendues solidaires d'un support plastique qui présente au moins une zone en trois dimensions en forme d'escalier composé de marches et de contremarches successives dans des plans sensiblement perpendiculaires. Les diodes sont fixées chacune sur une des marches du support, et elles sont alimentées et commandées par des pistes métalliques conductrices. Selon des caractéristiques particulièrement avantageuses de l'invention, les pistes conductrices sont formées par des épaisseurs de métal différentes selon qu'elles s'étendent le long des marches ou le long des contremarches. Ainsi, les pistes agencées sur une marche autour d'une diode électroluminescente sont réalisées par une épaisseur de métal incrustée au moins en partie dans le volume du support plastique, par exemple dans des encoches ou des sillons formés dans l'épaisseur de la marche, alors que les pistes agencées le long des contremarches sont réalisées par une surépaisseur de métal plus faible, de préférence rapportée sur la surface de la contremarche. Avantageusement, les pistes réalisées sur les marches autour de la diode électroluminescente sont réalisées par pression à chaud d'une feuille métallique sur chacune de ces marches alors que les pistes réalisées le long des contremarches sont obtenues par tout autre moyen. Alternativement, les pistes réalisées sur les marches autour de la diode électroluminescente sont réalisées par ablation laser du support afin de créer des sillons profonds dans la surface suivi d'une métallisation par dépôt autocatalytique ou par électrodéposition. En alternative, on peut créer ces pistes plus épaisses par dépôt par plasma. Ainsi, on combine avantageusement la réalisation de pistes relativement plus épaisses par ablation laser puis métallisation ou par dépôt plasma ou par pression à chaud d'une feuille métallique dans le support plastique, selon une méthode dite de "hot-embossing", qui permet de réaliser des couches de métallisation importantes, c'est à dire en profondeur et intégrées au moins en partie dans le volume du support de diodes, là où elles sont nécessaires, c'est-à-dire à proximité de la diode électroluminescente qui nécessite ce traitement thermique, avec d'autres techniques de fabrication pour ce qui est de l'intégration des circuits imprimés dans les contremarches, qui elles ne portent pas de diode et n'ont qu'une fonction géométrique et de conduction électrique.

Selon une caractéristique de l'invention, les pistes réalisées sur les marches autour de la diode électroluminescente ont une épaisseur d'au moins 20 micromètres, préférentiellement comprises entre 20 et 60 micromètres. Les pistes agencées le long des contremarches ont une épaisseur d'environ 10 à 12 micromètres. Selon différentes caractéristiques de l'invention, on pourra envisager que les pistes conductrices rapportées sur les contremarches peuvent l'être soit par une technologie MID, comme le dépôt d'encre conductrice, la galvanisation suivie d'ablation laser, puisque cette surface ne supportant pas les diodes ne nécessite pas une épaisseur de métallisation importante, soit par des connectiques simples permettant l'interconnexion électrique de chacune des marches entre elles.

On propose ainsi un dispositif d'éclairage et/ou de signalisation permettant de répondre aux attentes architecturales des créateurs automobiles, puisque le support de diode est en trois dimensions, avec un coût de réalisation du support des diodes et des circuits intégrés qui est plus faible que celui d'une technique de galvanisation intégrale du support par exemple, et en présentant une résistance accrue par rapport aux réalisations avec les techniques de circuits imprimés flexibles.

Selon différentes caractéristiques de l'invention :
- les pistes agencées le long des contremarches sont rapportées sur les contremarches par dépôt d'encre. Dans ce type de réalisation, on réalise avantageusement des gouttes en surépaisseur à la jonction entre les marches et les contremarches pour former une continuité électrique entre les pistes agencées sur les marches et les pistes agencées sur les contremarches.
- l'épaisseur de métal incrustée au moins en partie dans la matière plastique formant les marches est plus importante que l'épaisseur de métal rapportée sur la matière plastique formant surface des contremarches.
- les diodes et les pistes conductrices sont disposées sur la même face du support de diodes.
- les marches, et respectivement les contremarches, sont agencées de manière à s'étendre dans des plans sensiblement parallèles les uns par rapport aux autres.

L'invention concerne également un module d'éclairage et/ou de signalisation comportant un boîtier fermé par une glace de protection et à l'intérieur duquel sont fixés un support de diodes tridimensionnel tel qu'il vient d'être présenté ainsi qu'un réflecteur adapté à orienter le faisceau lumineux issu des diodes dans la direction souhaitée en sortie du module. Le support de diodes présente une face avant orientée en regard du réflecteur et sur laquelle les diodes sont rapportées. Là encore, ces diodes sont reliées par des pistes électriques conductrices qui ont une épaisseur plus importante au niveau des marches porteuses des diodes qu'au niveau des contremarches.

L'invention concerne en outre un procédé d'obtention d'un dispositif d'éclairage et/ou de signalisation présentant un support plastique tridimensionnel pour une pluralité de diodes électroluminescentes, dans lequel les pistes conductrices d'alimentation des diodes sont d'épaisseurs différentes selon que ces pistes s'étendent le long des marches ou le long des contremarches. Selon une première variante, les pistes réalisées sur les marches autour de la diode électroluminescente sont réalisées par emboutissage du support et pression à chaud d'une feuille métallique dans des logements formés dans le volume du support par l'emboutissage, et les pistes réalisées le long des contremarches sont obtenues par tout autre moyen, par exemple par un dépôt d'encre conductrice. Selon une seconde variante, les pistes réalisées sur les marches autour de la diode électroluminescente sont réalisées par ablation laser du support afin de créer des sillons profonds dans la surface suivi d'une métallisation par dépôt autocatalytique ou par électrodéposition. Selon une troisième variante, les pistes métalliques sont crées par dépôt par plasma. Avantageusement, la réalisation des pistes incrustées dans la matière du support au niveau des marches et la réalisation des pistes par dépôt d'encre conductrice le long des contremarches sont effectuées en deux opérations successives, le support plastique tridimensionnel étant tourné entre ces deux opérations pour que la réalisation des pistes incrustées dans la matière du support au niveau des marches soit effectuée dans un plan donné et que la réalisation des pistes par dépôt d'encre conductrice le long des contremarches soit effectuée dans un plan sensiblement perpendiculaire.

Selon une caractéristique de l'invention, ces étapes de procédé sont ensuite suivies de la connexion des diodes sur chacune des marches du support sur laquelle a été incrusté le circuit imprimé par pressage à chaud d'une feuille.

Ainsi, on réalise la métallisation de l'ensemble du support en deux étapes successives pour lesquelles l'accès à la pièce est à chaque fois facilité par le changement d'axe. On comprend que le support de diode présente des marches de forme plane suffisamment grandes pour effectuer correctement l'étape d'impression à chaud de la feuille sur les marches du support, et on comprend que les contremarches sont destinées à être recouvertes métalliquement lors de la deuxième étape d'interconnexion qui ne nécessite le dépôt que d'une couche faible de métal, l'obligation de traitement thermique de la chaleur dégagée par la diode électroluminescente étant principalement prise en charge par la couche de métal plus épaisse disposée sur la partie plane des marches.

L'invention et les avantages qui en découlent vont être décrits dans la description détaillée et non limitative qui va suivre, et qui sera faîte au regard des dessins annexés, parmi lesquels :
- la figure 1 est une vue en perspective d'un dispositif d'éclairage et/ou de signalisation selon l'invention, associé à un réflecteur ;
- la figure 2 est une vue en perspective du dispositif de la figure 1, vu de l'autre côté et dans lequel on distingue le support de diodes, muni des diodes et des circuits imprimés d'alimentation de ces diodes, et
- la figure 3 est une représentation schématique en coupe d'un détail du support de diode illustré sur la figure 2, montrant notamment deux diodes électroluminescentes parmi la pluralité supportée, ainsi que les pistes conductrices associées à ces deux diodes et leurs interconnexions.

Le dispositif d'éclairage et/ou de signalisation selon l'invention comporte un support de diodes 2 en trois dimensions, sur lequel est rapportée une pluralité de diodes électroluminescentes 4 reliées chacune par des pistes 6 conductrices électriquement pour transmettre l'alimentation et l'information de commande.

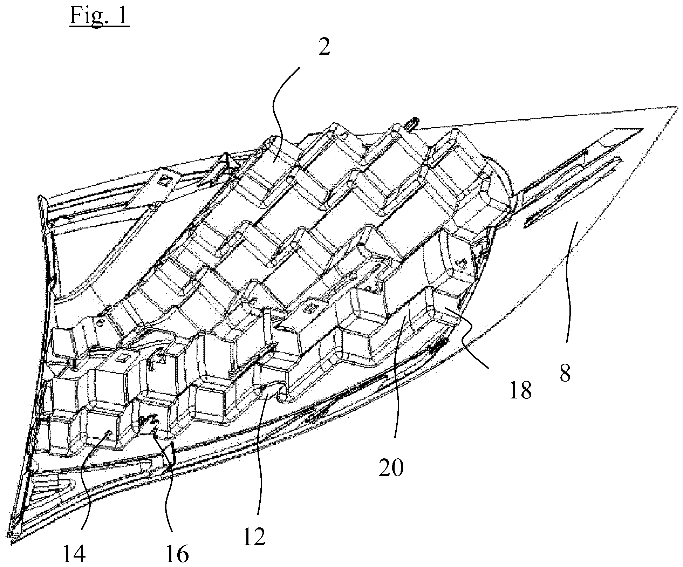

Le dispositif est particulièrement adapté à être logé dans un module d'éclairage et/ou de signalisation de véhicules automobiles formé d'un boîtier logeant le support de diodes et d'une glace de projection venant refermer le boîtier et emprisonner le support. En outre, tel qu'illustré sur la figure 1, le support de diodes est adapté dans ce module d'éclairage et/ou de signalisation à être disposé en regard d'un réflecteur 8, qui va permettre d'obtenir l'orientation finale souhaitée du faisceau lumineux issu des diodes électroluminescentes.

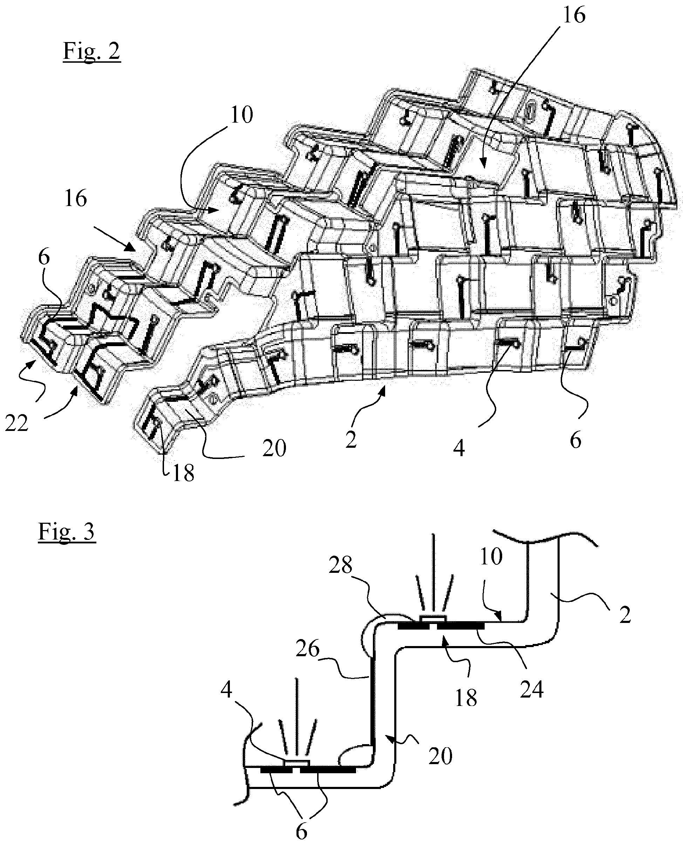

Le support de diodes présente une face avant 10, tournée vers le réflecteur, les diodes étant chacune disposées sur des parties planes de cette face avant pour que le faisceau de lumière en sortie de chacune des diodes soit dirigé vers la paroi du réflecteur en regard. On comprend que le support, les diodes électroluminescentes et le projecteur sont aménagés de telle sorte que la lumière émise le soit en direction de la glace de projection, pour éclairer ou signaler vers l'extérieur du véhicule. A cet effet, de façon connue, l'ensemble formé par le réflecteur et le support de diodes est agencé pour que chacune des diodes soit disposée sur un foyer du réflecteur. Des moyens d'indexage sont portés respectivement par le support et par le réflecteur pour assurer la position des diodes sur ces foyers. Des pions latéraux 12 et des ergots 14 (visibles sur la figure 1) s'étendent en saillie du plan principal du réflecteur et des encoches correspondantes 16 (visibles sur les figures 1 et 2) sont formées dans les parois du support de diode pour former ces moyens d'indexage. On s'assure que la présence des parois porteuses des pions et des ergots ne gêne pas la diffusion de la lumière en sortie des diodes.

Le support de diodes du dispositif selon l'invention présente une zone tridimensionnelle en forme d'escalier, comportant une succession de marches 18 et de contremarches 20 agencées dans des plans sensiblement perpendiculaires. Tel qu'illustré sur la figure 2, le support de diodes peut être défini par plusieurs séries d'escalier 22 disposées en contrebas l'une de l'autre. En se référant à la direction d'émission longitudinale des diodes disposées sur le support, on parlera par la suite d'un agencement des marches dans un plan transversal, et d'un agencement des contremarches dans un plan longitudinal.

Les diodes électroluminescentes sont disposées une à une sur les marches, une diode par marche. Les diodes sont fixées par collage sur la face avant du support de diode. Les marches sont disposées dans des plans parallèles entre eux, de manière à ce que les faisceaux issus des diodes s'étendent sensiblement parallèlement dans la même direction.

On comprendra que le design de la pièce de support pourra être modifié sans sortir du contexte de l'invention, et présenter par exemple plus ou moins de marches et donc plus ou moins de diodes électroluminescentes. Toutefois, il convient selon l'invention que chacune des marches adaptées à recevoir une diode électroluminescente présente une surface, sur laquelle est rapportée la diode, qui est suffisamment plane.

Les pistes conductrices, servant à l'alimentation des diodes et à la communication des instructions de commande d'éclairage, s'étendent de manière continue sur tout le support, d'une marche à l'autre, en passant par les contremarches.

Selon l'invention, tel que cela est visible sur la figure 3, le support de diodes est particulier en ce que les pistes conductrices sont formées par des épaisseurs de métal différentes selon qu'elles sont appliquées sur les marches ou sur les contremarches. En particulier les pistes conductrices s'étendent au moins en partie dans le volume de la pièce plastique, comme incrustées dans la matière, ou à la surface de cette pièce plastique, comme déposées sur la matière, selon qu'elles sont appliquées sur les marches ou sur les contremarches et la technique de réalisation utilisée.

En effet, s'il est exact que les pistes métalliques sont conductrices de façon continue sur tout le circuit, on observe que l'épaisseur de métallisation utilisée pour la réalisation de ces pistes dans ou sur la matière plastique du support est différente selon qu'elle soit appliquée aux marches ou aux contremarches. L'épaisseur de métallisation est plus importante sur les marches, c'est-à-dire à proximité de chacune des diodes électroluminescentes, que sur les contremarches. Comme cela a pu être précisé précédemment, le métal sert à la fois à la communication des informations depuis le module de commande vers chacune des diodes réparties sur le support de diodes, et il sert en outre au refroidissement des diodes, l'efficacité de celui-ci étant proportionnelle à l'épaisseur du métal présent au voisinage de la diode. Plus l'épaisseur de métal est importante, meilleur est le refroidissement.

Cette épaisseur importante de métal sur les marches est selon une première variante obtenue par la pression à chaud d'un film métallique de l'épaisseur souhaitée, d'où la nécessité d'une planéité correcte de la marche formant face d'accueil de la diode. La pression à chaud du film métallique sur la marche est faite selon une technique connue sous la dénomination de " hot embossing ", dans laquelle une feuille métallique présentant l'épaisseur de métal souhaitée est disposée contre chacune des marches.

La première étape de cette technique est de placer le support plastique vierge dans un bâti reproduisant la forme tridimensionnelle en escalier du support, pour que ce dernier puisse être en appui contre le bâti et garder une rigidité suffisante lors de l'étape de pression à venir.

On oriente le bâti de manière adéquate pour que le support plastique présente de façon apparente, et appropriée au dépôt de la feuille métallique, la face avant de chacune des marches.

La feuille métallique est déposée sur les marches, sur la face avant adaptée à recevoir par la suite la diode. Il est possible de ne prévoir qu'une seule feuille métallique venant recouvrir l'ensemble du support, ou de prévoir des feuilles métalliques distinctes propres à chacune des marches et au dessin des pistes que l'on souhaite réaliser sur ces marches.

Une presse est alors appliquée contre le support de diodes en emprisonnant la (ou les) feuille(s) métallique(s). La face de la presse amenée à entrer en contact avec la feuille métallique comporte des nervures qui s'étendent en saillie de cette face selon une disposition correspondante à l'agencement des pistes conductrices que l'on souhaite intégrer sur les marches du support de diodes.

On peut prévoir, sans sortir du contexte de l'invention, une presse présentant une face de contact plane bidimensionnelle qui est rapportée sur chacune des marches et qui crée pour chacune le même agencement de pistes, ou bien une presse présentant une face de contact tridimensionnelle qui déforme l'ensemble des marches en une seule frappe, ceci étant possible par la disposition parallèle des plans dans lesquels s'étendent les marches.

Le mouvement de la presse s'arrête lorsque la face de contact est en butée contre la face avant du support. Les nervures en saillie de la face de contact déforment alors la face avant du support au niveau des marches en créant des logements 24 prenant la forme de sillons ou d'encoches (visibles sur la figure 3) de dimensions et d'agencement correspondants à ceux des nervures. On comprendra, tel que cela a pu être schématisé à titre d'exemple, que les logements formés sur une même marche pourront présenter des dimensions et des profondeurs différentes, notamment en fonction de leur proximité avec la diode électroluminescente adaptée à être collée sur cette marche, et que les nervures correspondantes formées en saillie sur la presse peuvent de fait prendre des formes et des dimensions différentes entre elles.

Par cette pression à chaud, la feuille métallique est déformée pour suivre la descente de la presse et elle est enfoncée dans l'épaisseur du support dans chacun des sillons crées. Il convient alors de retirer le surplus de la feuille métallique qui ne se retrouve pas intégré dans le volume du support de diodes.

Cette technique de pressage à chaud, utilisée classiquement pour des pièces en deux dimensions, est ici combinée avec une autre méthode pour réaliser des pistes conductrices électriquement sur les contremarches et assurer la continuité électrique entre les circuits imprimés rapportés sur les marches. Cette autre méthode peut être choisie parmi plusieurs techniques connues, étant entendue que l'exigence d'une épaisseur importante de métal ne s'applique qu'au dépôt de métal sur les marches.

Tel qu'illustré sur la figure 3, on réalise avantageusement cette continuité électrique par le dépôt d'une couche d'encre conductrice 26 sur les contremarches. Ceci permet de contrôler la surface effective de dépôt de pistes conductrices et de la limiter à la seule fonction de continuité électrique des pistes injectées dans le volume des marches, puisqu'il n'est pas besoin ici d'assurer une fonction de refroidissement des diodes. En outre, la technique de dépôt d'encre permet de réaliser facilement les jonctions entre les plans perpendiculaires par la formation de gouttes en surépaisseur 28.

Il en résulte qu'au niveau des marches, les pistes sont intégrées au moins en partie dans le volume du support de diodes, incrustées dans le support, alors qu'au niveau des contremarches, les pistes sont plaquées contre la face avant du support, en surépaisseur. Tel que cela a pu être décrit précédemment, les pistes incrustées dans le volume du support au niveau des marches présentent avantageusement une épaisseur supérieure à celle des pistes plaquées contre le support au niveau des contremarches.

On a observé précédemment que les marches recevant les diodes, et donc réalisé par la même méthode de pressage à chaud, sont toutes sensiblement parallèles et disposées dans le même plan transversal. Le pressage à chaud peut ainsi être réalisé tel que décrit précédemment, en une opération ou en autant d'opération qu'il y a de marches mais sans toutefois bouger la pièce support. Ceci est particulièrement avantageux, puisque les coûts de réalisation de la machine sont limités.

Il suffit alors dans le procédé de réalisation du dispositif selon l'invention de tourner la machine lorsque toutes les marches porteuses de diodes sont incrustées de circuits électriques, pour que l'on réalise alors dans une même étape continue le dépôt de couches conductrices pour réaliser les interconnexions sur les contremarches.

Selon une autre variante, les pistes réalisées sur les marches autour de la diode électroluminescente sont réalisées par ablation laser du support afin de créer des sillons profonds dans la surface suivi d'une métallisation par dépôt autocatalytique ou par électrodéposition, par exemple selon la méthode exposée dans la demande de brevet US2014/0374141.

Selon une dernière variante, les pistes réalisées sur les marches autour de la diode électroluminescente sont réalisées par dépôt par plasma.

La description qui vient d'être faite explique clairement les avantages de l'invention, en particulier la réduction des coûts d'obtention de la pièce, tridimensionnelle pour répondre aux exigences des constructeurs automobiles. La combinaison de deux procédés de réalisation d'incrustation ou de dépôt d'éléments métalliques par rapport à une pièce plastique, choisi correctement en fonction de la zone d'application de ces circuits électriques, permet d'éviter les coûts de fabrication trop importants d'un bain chimique dans lequel on pourrait envisager de tremper la pièce support plastique dans son intégralité et elle permet également d'éviter l'obtention d'une pièce avec des épaisseurs de métal trop faibles sur toute sa face métallisée, ce qui pourrait générer une surchauffe de la pièce et une défaillance du dispositif d'éclairage et/ou de signalisation. Il est particulièrement judicieux d'utiliser les méthodes dites de "hot-embossing" pour les surfaces planes portant les diodes, et d'associer cette méthode de réalisation à une méthode plus conventionnelle, moins coûteuse et génératrice de moins de métal pour les zones d'interconnexions. Il convient de noter que la technique de "hot-embossing" est connue pour être efficace sur des pièces en deux dimensions, de telle sorte que l'homme du métier n'aurait pas eu intérêt, sauf à imaginer l'utilisation de cette technique en combinaison avec d'autres techniques pour la métallisation des interconnexions, à utiliser cette technique dans le cadre d'un support tridimensionnel.

## Revendications

1. Dispositif d'éclairage et/ou de signalisation comportant une pluralité de diodes électroluminescentes (4) rendues solidaires d'un support plastique (2) qui présente au moins une zone en trois dimensions en forme d'escalier composé de marches (18) et de contremarches (20) successives dans des plans sensiblement perpendiculaires, chacune des diodes étant fixée respectivement sur une des marches dudit support, les diodes étant alimentées par des pistes métalliques conductrices (6), **caractérisé en ce que** les pistes conductrices sont formées par des épaisseurs de métal différentes selon que les pistes s'étendent le long des marches ou le long des contremarches, l'épaisseur de métal incrustée dans la matière plastique formant les marches (18) est plus importante que l'épaisseur de métal rapportée ou incrustée sur la matière plastique formant surface des contremarches (20).les pistes agencées sur une marche autour d'une diode électroluminescente étant réalisées par une épaisseur de métal incrusté dans le volume du support plastique, dans des logements (24) formés dans l'épaisseur de la marche, alors que les pistes agencées le long des contremarches sont réalisées par une surépaisseur de métal rapportée ou incrustée sur la surface de la contremarche.

2. Dispositif selon la revendication 1, **caractérisé en ce que** les pistes (6) agencées sur une marche (18) autour d'une diode électroluminescente (4) sont réalisées par la pression à chaud d'une feuille métallique sur la marche alors que les pistes agencées le long des contremarches (20) sont réalisées par tout autre moyen de manière à permettre la continuité de la conduction électrique entre chacune des marches.

3. Dispositif selon la revendication 1 ou 2, **caractérisé en ce que** les pistes (6) agencées le long des contremarches (20) sont rapportées sur les contremarches par injection d'une couche d'encre (26).

4. Dispositif selon la revendication 3, **caractérisé en ce que** des gouttes en surépaisseur (28) sont formées à la jonction entre les marches (18) et les contremarches (20) pour former une continuité électrique entre les pistes agencées sur les marches et les pistes agencées sur les contremarches.

5. Dispositif selon la revendication 1, **caractérisé en ce que** les pistes (6) agencées sur une marche (18) autour d'une diode électroluminescente (4) sont réalisées par ablation laser du support afin de créer des sillons profonds dans la surface suivi d'une métallisation par dépôt autocatalytique ou par électrodéposition.

6. Dispositif selon l'une des revendications 1 à 5, **caractérisé en ce que** les diodes (4) et les pistes conductrices (6) sont disposées sur la même face (10) du support de diodes (2).

7. Dispositif selon la revendication 1, **caractérisé en ce que** les marches (18) sont agencées de manière à s'étendre dans des plans sensiblement parallèles les uns par rapport aux autres.

8. Dispositif selon la revendication 1, **caractérisé en ce que** les contremarches (20) sont agencées de manière à s'étendre dans des plans parallèles les uns par rapport aux autres.

9. Procédé d'obtention d'un dispositif d'éclairage et/ou de signalisation présentant un support plastique tridimensionnel (2) pour une pluralité de diodes électroluminescentes (4) selon l'une des revendications 1 à 8, dans lequel les pistes conductrices (6) d'alimentation des diodes sont d'épaisseurs différentes selon que ces pistes s'étendent le long des marches (18) ou le long des contremarches (20), les pistes réalisées sur les marches autour de la diode électroluminescente étant réalisées par emboutissage du support et pression à chaud d'une feuille métallique dans les logements (24) formés dans le volume de du support alors que les pistes réalisées le long des contremarches sont obtenues par tout autre moyen et sont d'épaisseur moindre.

10. Procédé selon la revendication 9, dans lequel la réalisation des pistes (6) rapportées le long des contremarches (20) est effectuée par un dépôt d'encre conductrice (26).

11. Procédé selon la revendication 10, dans lequel la réalisation des pistes (6) injectées dans la matière du support au niveau des marches (18) et la réalisation des pistes par dépôt d'encre conductrice le long des contremarches (20) sont effectuées en deux opérations successives, le support plastique tridimensionnel (2) étant tourné entre ces deux opérations pour que la réalisation des pistes injectées dans la matière du support au niveau des marches soit effectuée dans un plan donné et que la réalisation des pistes par dépôt d'encre conductrice le long des contremarches soit effectuée dans un plan sensiblement perpendiculaire.

## Patentansprüche

1. Beleuchtungs- und/oder Signalgebungsvorrichtung, die mehrere Leuchtdioden (4) umfasst, die an einem Kunststoffträger (2) befestigt sind, der wenigstens eine dreidimensionale Zone in Form einer Treppe aufweist, die aus Trittstufen (18) und Setzstufen (20), die in zueinander im Wesentlichen senkrechten Ebenen aufeinander folgen, aufgebaut ist, wobei jede der Dioden an einer der Trittstufen des Trägers befestigt ist, wobei die Dioden durch leitende Metallbahnen (6) versorgt werden, **dadurch gekennzeichnet, dass** die leitenden Bahnen durch unterschiedliche Metalldicken, je nachdem, ob die Bahnen längs der Trittstufen oder längs der Setzstufen verlaufen, gebildet sind, wobei die in den Kunststoff inkrustierte Metalldicke, die die Trittstufen (18) bildet, größer ist als die Metalldicke, die in den Kunststoff, der die Oberfläche der Setzstufen (20) bildet, eingelassen oder inkrustiert ist, wobei die Bahnen, die auf einer Trittstufe um eine Leuchtdiode angeordnet sind, durch eine Metalldicke verwirklicht sind, die in das Volumen des Kunststoffträgers in Aufnahmeräumen (24), die in der Dicke der Trittstufe gebildet sind, inkrustiert ist, während die Bahnen, die längs der Setzstufen angeordnet sind, durch eine Metallüberdicke verwirklicht sind, die in die Oberfläche der Setzstufe eingelassen oder inkrustiert ist.

2. Vorrichtung nach Anspruch 1, **dadurch gekennzeichnet, dass** die Bahnen (6), die auf einer Trittstufe (18) um eine Leuchtdiode (4) angeordnet sind, durch Heißpressen einer Metallfolie auf die Trittstufe verwirklicht sind, während die Bahnen, die längs der Setzstufen (20) angeordnet sind, durch jedes andere Mittel verwirklicht sind, um die Kontinuität der elektrischen Leitung zwischen jeder der Trittstufen zu ermöglichen.

3. Vorrichtung nach Anspruch 1 oder 2, **dadurch gekennzeichnet, dass** die Bahnen (6), die längs der Setzstufen (20) angeordnet sind, in die Setzstufen durch Einleiten einer Farbschicht (26) eingelassen sind.

4. Vorrichtung nach Anspruch 3, **dadurch gekennzeichnet, dass** überdicke Tropfen (28) am Übergang zwischen den Trittstufen (18) und den Setzstufen (20) gebildet sind, um eine elektrische Kontinuität zwischen den Bahnen, die auf den Trittstufen angeordnet sind, und den Bahnen, die auf den Setzstufen angeordnet sind, zu bilden.

5. Vorrichtung nach Anspruch 1, **dadurch gekennzeichnet, dass** die Bahnen (6), die auf einer Trittstufe (18) um eine Leuchtdiode (4) angeordnet sind, durch Laserablation des Trägers verwirklicht sind, um in der Oberfläche tiefe Furchen zu erzeugen, gefolgt von einer Metallisierung durch autokatalytischen Niederschlag oder durch Elektroabscheidung.

6. Vorrichtung nach einem der Ansprüche 1 bis 5, **dadurch gekennzeichnet, dass** die Dioden (4) und die Leiterbahnen (6) auf derselben Fläche (10) des Diodenträgers (2) angeordnet sind.

7. Vorrichtung nach Anspruch 1, **dadurch gekennzeichnet, dass** die Trittstufen (18) in der Weise angeordnet sind, dass sie sich in zueinander im Wesentlichen parallelen Ebenen erstrecken.

8. Vorrichtung nach Anspruch 1, **dadurch gekennzeichnet, dass** die Setzstufen (20) in der Weise angeordnet sind, dass sie sich in zueinander parallelen Ebenen erstrecken.

9. Verfahren zum Erhalten einer Beleuchtungs- und/oder Signalgebungsvorrichtung mit einem dreidimensionalen Kunststoffträger (2) für mehrere Leuchtdioden (4) nach einem der Ansprüche 1 bis 8, wobei die Leiterbahnen (6) für die Versorgung der Dioden unterschiedliche Dicken haben, je nachdem, ob sich diese Bahnen längs der Trittstufen (18) oder längs der Setzstufen (20) erstrecken, wobei die Bahnen, die auf den Trittstufen um die Leuchtdiode verwirklicht sind, durch Tiefziehen des Trägers und Heißpressen einer Metallfolie in die Aufnahmeräume (24), die in dem Volumen des Trägers gebildet sind, verwirklicht werden, während die Bahnen, die längs der Setzstufen verwirklicht sind, durch jedes andere Mittel erhalten werden und eine geringere Dicke besitzen.

10. Verfahren nach Anspruch 9, wobei die Verwirklichung der Bahnen (6), die längs der Setzstufen (20) eingefügt sind, durch Niederschlag (26) einer leitenden Farbe erfolgt.

11. Verfahren nach Anspruch 10, wobei die Verwirklichung der Bahnen (6), die in das Material des Trägers auf Höhe der Trittstufen (18) eingespritzt werden, und die Verwirklichung der Bahnen durch Niederschlag einer leitenden Farbe längs der Setzstufen (20) in zwei aufeinander folgenden Operationen erfolgen, wobei der dreidimensionale Kunststoffträger (2) zwischen diesen beiden Operationen gedreht wird, damit die Verwirklichung der Bahnen, die in das Material des Trägers auf Höhe der Trittstufen eingespritzt werden, in einer gegebenen Ebene erfolgt und damit die Verwirklichung der Bahnen durch Niederschlag einer leitenden Farbe längs der Setzstufen in einer im Wesentlichen senkrechten Ebene erfolgt.

## Claims

1. Lighting and/or signaling device comprising a plurality of light-emitting diodes (4) secured to a plastic support (2) which has at least one three-dimensional zone in the form of a staircase made up of successive treads (18) and risers (20) in substantially perpendicular planes, each of the diodes being fixed respectively to one of the treads of said support, the diodes being powered by conductive metallic tracks (6), **characterized in that** the conducting tracks are formed by thicknesses of metal that differ according to whether the tracks extend along the treads or along the risers, the thickness of metal encrusted into the plastic forming the treads (18) is greater than the thickness of metal added or encrusted onto the plastic forming the surface of the risers (20), the tracks arranged on a tread around a light-emitting diode being produced by a thickness of metal encrusted into the volume of the plastic support, in housings (24) formed in the thickness of the tread, whereas the tracks arranged along the risers are produced by an overthickness of metal which is attached or encrusted onto the surface of the riser.

2. Device according to Claim 1, **characterized in that** the tracks (6) arranged on a tread (18) around a light-emitting diode (4) are produced by hot-pressing a metallic sheet onto the tread whereas the tracks arranged along the risers (20) are produced by any other means so as to allow continuity of the conduction of electricity between each of the treads.

3. Device according to Claim 1 or 2, **characterized in that** the tracks (6) arranged along the risers (20) are attached to the risers by injecting a layer of ink (26).

4. Device according to Claim 3, **characterized in that** droplets of overthickness (28) are formed at the junction between the treads (18) and the risers (20) to form electrical continuity between the tracks arranged on the treads and the tracks arranged on the risers.

5. Device according to Claim 1, **characterized in that** the tracks (6) arranged on a tread (18) around a light-emitting diode (4) are produced by laser ablation of the support so as to create deep grooves in the surface, followed by metalization by autocatalytic deposition or by electrodeposition.

6. Device according to one of Claims 1 to 5, **characterized in that** the diodes (4) and the conducting tracks (6) are arranged on the same face (10) of the diode support (2).

7. Device according to Claim 1, **characterized in that** the treads (18) are arranged so that they extend in planes substantially parallel to one another.

8. Device according to Claim 1, **characterized in that** the risers (20) are arranged so that they extend in planes parallel to one another.

9. Method of obtaining a lighting and/or signaling device having a three-dimensional plastic support (2) for a plurality of light-emitting diodes (4) according to one of Claims 1 to 8, in which the conducting tracks (6) supplying power to the diodes are of thicknesses that differ according to whether these tracks extend along the treads (18) or along the risers (20), the tracks produced on the treads around the light-emitting diode being produced by embossing the support and by hot-pressing a metallic sheet into the housings (24) formed in the volume of the support, whereas the tracks produced along the risers are obtained by any other means and are of lesser thickness.

10. Method according to Claim 9, in which the tracks (6) attached along the risers (20) are produced by depositing conducting ink (26).

11. Method according to Claim 10, in which the tracks (6) injected into the material of the support at the treads (18) and the tracks produced by depositing conducting ink along the risers (20) are produced in two successive operations, the three-dimensional plastic support (2) being turned between these two operations so that the tracks injected into the material of the support at the treads are produced in a given plane and so that the tracks produced by depositing conducting ink along the risers are produced in a substantially perpendicular plane.
